# EUROPÄISCHE PATENTSCHRIFT

(11) **EP 2 636 082 B1**
(45) Veröffentlichungstag und Bekanntmachung des Hinweises auf die Patenterteilung: **28.01.2015**
(21) Anmeldenummer: 11776750.9
(22) Anmeldetag: 26.10.2011
(51) Int. Cl.: H01L 41/23

(54) **VERFAHREN ZUR HERSTELLUNG EINER AKTOREINHEIT MIT EINER HÜLSE ZUR AUFNAHME EINES PIEZOAKTORS**
METHOD FOR PRODUCING AN ACTUATOR UNIT WITH SLEEVE FOR RECEIVING A PIEZOACTUATOR
PROCÉDÉ DE PRODUCTION D'UNE UNITÉ ACTIONNEUR AVEC DOUILLE DESTINÉE À RECEVOIR UN ACTIONNEUR PIÉZOÉLECTRIQUE

(30) Priorität: 02.11.2010 DE 102010050265
(43) Veröffentlichungstag der Anmeldung: 11.09.2013
(73) Patentinhaber: Epcos AG, 81669 München (DE)
(72) Erfinder: KREITER, Johann, 8530 Deutschlandsberg (AT); FELLNER, Siegfried, 8413 St. Georgen (AT); KÜGERL, Georg, 8552 Eibiswald (AT)
(74) Vertreter: Epping - Hermann - Fischer
(86) Internationale Anmeldenummer: PCT/EP2011/068756
(87) Internationale Veröffentlichungsnummer: WO 2012/059378

(56) Entgegenhaltungen:
- DE-A1-102004 011 696
- DE-A1-102007 004 552
- US-A1- 2004 113 525
- US-A1- 2010 052 214

## Beschreibung

Es wird ein Verfahren zur Herstellung einer Aktoreinheit sowie eine Hülse zur Aufnahme eines Piezoaktors angegeben.

Piezoaktoren umfassen oftmals mehrere Schichten eines piezoelektrischen Materials. Piezoaktoren können zum Beispiel zum Betätigen eines Einspritzventils in einem Kraftfahrzeug eingesetzt werden. Eine Hülse ist zum Schutz eines Piezoaktors vor Umwelteinflüssen von Bedeutung, wenn die Lebensdauer des Piezoaktors möglichst lang gehalten werden soll.

Piezoaktoren sind beispielsweise aus der DE 10 2004 031 404 A1 und der DE 10 2006 025 177 A1 bekannt. Die Druckschrift DE 102004011696 A1 betrifft ein Verfahren zum Vergießen einer zylindrischen Montagehülse mit einer aushärtbaren Vergussmasse, wobei innerhalb der Montagehülse ein piezoelektrischer Stapelaktor angeordnet ist. Die Druckschrift US 2010/052214 A1 betrifft ein Piezoaktorbauelement, das in einer Hülse angeordnet ist. Ein Ende der Hülse ist mit einem Deckel verschlossen, während das andere Ende der Hülse von einem Sockel, auf dem der Piezoaktor angeordnet ist, verschlossen ist. Ein Spalt zwischen der Hülse und dem Piezoaktor wird durch an der Hülse seitlich angebrachte Einspritznadeln mit einer Vergussmasse gefüllt. Die Druckschrift DE 102007004552 A1 betrifft ein Verfahren zur Herstellung eines Piezoaktormoduls, das von einer Schutzummantelung umgeben ist. Die Schutzummantelung besteht aus einem Schutzschichtsystem mit einem als Verguss aufgebrachten Isolationsmedium sowie einer darüber angeordneten Ummantelung. Bei der Herstellung des Piezoaktormoduls wird eine als verlorene Form ausgeführte Vergussform verwendet, die als Ummantelung über dem Isolationsmedium verbleibt.

Eine Aufgabe ist es, ein neues Verfahren zur Herstellung einer Aktoreinheit oder eine neue Hülse anzugeben, wodurch insbesondere die Zuverlässigkeit und die Lebensdauer eines Piezoaktors erhöht wird.

Es wird ein Verfahren zur Herstellung einer Aktoreinheit angegeben. Die Aktoreinheit weist einen Piezoaktor auf. Die Aktoreinheit weist eine Hülse mit einer ersten Stirnfläche oder Stirnseite und einer zweiten Stirnfläche oder Stirnseite auf. Die Aktoreinheit weist eine Vergussmasse auf. In einem ersten Schritt erfolgt das Einbringen des Piezoaktors in die Hülse. Der Piezoaktor wird dabei von der Seite der Hülse mit der ersten Stirnfläche oder Stirnseite aus in die Hülse eingebracht. In einem zweiten Schritt wird eine Befüllöffnung eines Befüllelements, beispielsweise die Öffnung einer Nadel, in einer axialen Position nahe oder im Bereich der axialen Position der zweiten Stirnfläche oder Stirnseite der Hülse angeordnet. Insbesondere ist die Befüllöffnung näher an der zweiten Stirnfläche oder Stirnseite der Hülse als an der ersten Stirnfläche oder Stirnseite der Hülse angeordnet. Die axiale Position kann sich auf die Hauptachse der Hülse beziehen. Die Hauptachse bzw. Hauptlängsachse erstreckt sich zwischen der ersten Stirnfläche oder Stirnseite und der zweiten Stirnfläche oder Stirnseite der Hülse. In einem dritten Schritt wird ein Hohlraum, der zwischen einer Innenseite der Hülse und dem Piezoaktor gebildet ist, mit der Vergussmasse über die Befüllöffnung des Befüllelements befüllt. Der Hohlraum wird dabei derart befüllt, dass die Vergussmasse bis maximal an eine erste Stirnfläche des Piezoaktors reicht. Die erste Stirnfläche des Piezoaktors ist näher an der ersten Stirnfläche oder Stirnseite der Hülse angeordnet als eine zweite Stirnfläche des Piezoaktors. Das Verfahren umfasst weiterhin den Schritt, dass ein Dichtelement an der zweiten Stirnseite der Hülse vorzugsweise lösbar angeordnet wird. Das Dichtelement dient zum Abdichten der Hülse auf der Seite der zweiten Stirnseite. Das Anbringen des Dichtelements erfolgt vor dem Befüllen des Hohlraums. Weiterhin umfasst das Verfahren den Schritt des Aushärtens der Vergussmasse. In einem weiteren Schritt wird das Dichtelement von der zweiten Stirnseite der Hülse nach dem Aushärtevorgang entfernt.

Am Piezoaktor sind beispielsweise zwei Anschlusselemente vorgesehen. Die Anschlusselemente dienen zur externen Kontaktierung des Aktors. Die Anschlusselemente können beispielsweise an den Seitenflächen des Piezoaktors angeordnet sein. Vorzugsweise ist an zwei Seitenflächen des Piezoaktors je ein Anschlusselement aufgebracht. Die Anschlusselemente ragen zum Beispiel über die erste Stirnfläche des Piezoaktors hinaus

Die axiale Position der Befüllöffnung nahe oder im Bereich der axialen Position der zweiten Stirnfläche oder Stirnseite der Hülse ist vorteilhafterweise derart gewählt, dass Turbulenzen in der Vergussmasse, die beispielsweise verstärkt zu unerwünschten Lufteinschlüssen in der Vergussmasse führen können, beim Befüllvorgang vermieden werden.

Die Vergussmasse wird derart in die Hülse eingebracht, dass die Vergussmasse den Piezoaktor möglichst vollständig umgibt. Die Vergussmasse wird vorzugsweise derart in die Hülse eingebracht, dass die Vergussmasse bündig mit der ersten Stirnfläche des Piezoaktors abschließt. Insbesondere wird die Befüllung spätestens dann gestoppt, wenn die Vergussmasse bündig mit der ersten Stirnfläche des Piezoaktors abschließt. Dadurch wird verhindert, dass Vergussmasse das Niveau der ersten Stirnfläche des Piezoaktors überschreitet. Eine Bedeckung der ersten Stirnfläche des Piezoaktors und/oder der zur externen Kontaktierung des Piezoaktors aus der ersten Stirnfläche des Aktors herausragenden Anschlusselemente durch die Vergussmasse wird dadurch vermieden. Dies trägt zur Erhöhung der Lebensdauer und Zuverlässigkeit der Aktoreinheit, insbesondere des Piezoaktors, bei. Zudem wird eine Automatisierung der Herstellung der Aktoreinheit erleichtert, da aufwändige, zum Teil nicht automatisch durchführbare Reinigungsprozesse der ersten Stirnfläche und/oder der Anschlusselemente entfallen.

In einer vorteilhaften Ausführung bildet die zweite Stirnfläche oder Stirnseite der Hülse einen Boden der Hülse. Die zweite Stirnfläche oder Stirnseite weist vorteilhafterweise eine Öffnung auf. Der Piezoaktor wird so in die Hülse eingebracht, dass der Piezoaktor in die Öffnung eintritt.

Insbesondere wird die zweite Stirnfläche des Piezoaktors in die Öffnung ein bzw. durch diese hindurchgeführt. Die Öffnung ist beispielsweise ein Durchbruch. Der Durchbruch ist insbesondere ein Vierkantdurchbruch. Der Durchbruch weist eine Abmessung auf, welche in etwa der Abmessung der zweiten Stirnfläche des Piezoaktors entspricht. Vorzugsweise ist die Abmessung der zweiten Stirnfläche des Piezoaktors kleiner oder maximal gleich der Abmessung des Durchbruchs, so dass die zweite Stirnfläche des Piezoaktors leicht in den Durchbruch eingeführt werden kann. Auf Grund von Fertigungstoleranzen kann es zu einem Spalt zwischen der Öffnung an der zweiten Stirnseite der Hülse und dem Piezoaktor kommen. Durch diesen Spalt könnte Vergussmasse beim Vergießen der Aktoreinheit aus der Hülse über die Öffnung im Boden der Hülse austreten.

Das Dichtelement ist vorzugsweise derart an der zweiten Stirnfläche oder Stirnseite der Hülse angeordnet, dass ein Austreten der Vergussmasse aus der Hülse über die Seite der zweiten Stirnfläche oder Stirnseite der Hülse beim Befüllen des Hohlraums verhindert wird. Das Anbringen des Dichtelements kann beispielsweise nach dem Einbringen des Piezoaktors in die Hülse und vor dem Anordnen der Befüllöffnung in dem Hohlraum erfolgen.

Da das Dichtelement zweckmäßigerweise lösbar angebracht ist, kann dieses auf einfache Weise in einem automatischen Herstellungsschritt entfernt werden.

In einer vorteilhaften Ausführung wird das Befüllelement von der ersten Stirnfläche oder Stirnseite der Hülse aus in die Hülse eingeführt.

Das Befüllelement wird dabei bevorzugt von der Seite der ersten Stirnfläche oder Stirnseite der Hülse am Piezoaktors entlang in Richtung der zweiten Stirnfläche oder Stirnseite der Hülse geführt.

In einer vorteilhaften Ausführung wird das Befüllelement während des Befüllens des Hohlraums mit der Vergussmasse von der zweiten Stirnfläche oder Stirnseite der Hülse weg in Richtung der ersten Stirnfläche oder Stirnseite der Hülse und somit von der zweiten Stirnfläche oder Stirnseite der Hülse weg bewegt.

Insbesondere wird die Befüllöffnung des Befüllelements vorteilhafterweise während des Befüllens des Hohlraums oberhalb oder knapp unterhalb des Vergussmassenniveaus im Hohlraum gehalten. Dabei bedeutet "oberhalb oder knapp unterhalb des Vergussmassenniveaus" vorteilhafterweise 1 bis 2 mm oberhalb oder unterhalb des Vergussmassenniveaus. Durch eine derartige Führung des Befüllelements können Turbulenzen in der Vergussmasse, die beispielsweise verstärkt zu unerwünschten Lufteinschlüssen in der Vergussmasse führen können, vermieden werden.

In einer weiteren vorteilhaften Ausführung wird das Befüllelement von der zweiten Stirnfläche oder Stirnseite der Hülse aus in die Hülse eingebracht.

Zu diesem Zweck weist die zweite Stirnfläche oder Stirnseite der Hülse vorteilhafterweise wenigstens eine Einfüllöffnung, beispielsweise eine Bohrung, auf. Das Befüllelement, insbesondere die Befüllöffnung des Befüllelements, wird zum Befüllen des Hohlraums mit der Vergussmasse über die Einfüllöffnung in der zweiten Stirnfläche oder Stirnseite in den Hohlraum eingeführt. Insbesondere wird die Befüllöffnung des Befüllelements in eine erste Seite des Dichtelements eingeführt und tritt an einer zweiten Seite des Dichtelements wieder aus. Die zweite Seite des Dichtelements entspricht vorteilhafterweise der Seite des Dichtelements, welche an den Hohlraum der Hülse grenzt.

Die Einfüllöffnung ist verschieden von der bereits vorher beschriebenen Öffnung, durch die der Piezoaktor geführt ist. Die Einfüllöffnung weist eine Abmessung auf, die von der Abmessung der vorher beschriebenen Öffnung verschieden ist. Insbesondere weist die Einfüllöffnung eine kleinere Abmessung auf, als die vorher beschriebene Öffnung, durch die der Piezoaktor geführt ist. Die wenigstens eine Einfüllöffnung ist bezüglich der Hauptachse der Aktoreinheit bzw. der Hülse radial zu der vorher beschriebenen Öffnung in der zweiten Stirnfläche oder Stirnseite der Hülse versetzt. Dadurch kann das Befüllelement beim Einbringen in den Hohlraum am Piezoaktor entlang geführt werden. Nachdem das Befüllelement in den Hohlraum eingebracht worden ist, wird die Vergussmasse von der Seite der zweiten Stirnfläche oder Stirnseite aus in Richtung der ersten Stirnfläche oder Stirnseite der Hülse gedrückt. Das Befüllelement bleibt hierbei zum Beispiel stationär. Dadurch können Turbulenzen und somit Lufteinschlüsse in der Vergussmasse weitgehend vermieden werden. Dies trägt zur Erhöhung der Lebensdauer der Aktoreinheit bei.

In einer vorteilhaften Ausführung wird der Piezoaktor derart in die Hülse eingebracht, dass die erste Stirnfläche des Piezoaktors und die erste Stirnfläche oder Stirnseite der Hülse die gleiche axiale Position in Bezug auf die Hauptachse aufweisen.

Vorteilhafterweise entspricht die Höhe bzw. Länge der Hülse in etwa der Höhe des Piezoaktors. Dadurch kann erreicht werden, dass die Vergussmasse mit der ersten Stirnfläche des Piezoaktors und gleichzeitig mit der ersten Stirnfläche oder Stirnseite der Hülse bündig abschließt. Dadurch wird die Stabilität und Lebensdauer der Aktoreinheit erhöht. Eine automatische Fertigung der Aktoreinheit kann erleichtert werden, da die Vergussmasse immer auf ein bestimmtes Niveau, also bis maximal zu der ersten Stirnfläche des Piezoaktors und somit der Hülse, aufgefüllt wird und aufwändige Reinigungsarbeiten der ersten Stirnfläche des Piezoaktors sowie der Anschlusselemente von der Vergussmasse, die in zusätzlichen Schritten erfolgen müssten, somit überflüssig sind. Fertigungskosten können auf diese Weise reduziert werden.

Es wird weiterhin eine Hülse angegeben zur Aufnahme eines Piezoaktors. Die Hülse weist eine erste Stirnfläche oder Stirnseite und eine zweite Stirnfläche oder Stirnseite auf. In der zweiten Stirnfläche oder Stirnseite ist eine erste Öffnung vorgesehen. Radial bezüglich einer Hauptachse der Hülse zu der ersten Öffnung versetzt ist wenigstens eine weitere oder zweite Öffnung vorgesehen.

Die erste Öffnung ist verschieden bzw. getrennt von der zweiten Öffnung. Die erste Öffnung hat einen Durchmesser, der verschieden von dem Durchmesser der zweiten Öffnung ist. Insbesondere weist die erste Öffnung einen größeren Durchmesser auf, als die zweite Öffnung. Die Hülse ist dazu ausgelegt, den Piezoaktor vor Umwelteinflüssen, wie beispielsweise hohen Temperaturen, die etwa im Motorraum eines Kraftfahrzeugs auftreten, zu schützen. Die Hülse kann somit die Lebensdauer des Piezoaktors erhöhen. Vorzugsweise enthält die Hülse ein Material das hydrophobe Eigenschaften aufweist. Gleichzeitig sollte das Material eine zur Formstabilisierung der Vergussmasse ausreichende mechanische Festigkeit bzw. Stabilität aufweisen. Weiterhin sollte besagtes Material gegenüber Temperaturen beständig sein. Vorzugsweise enthält die Hülse ein Material umfassend ein thermoplastisches Polyester, beispielsweise Polybutylenterephthalat (PBT). PBT hat weiterhin den Vorteil, dass das Material auf Grund seiner chemischen Stabilität nicht zum Piezoaktor absondert und diesen chemisch verunreinigt.

In einer vorteilhaften Ausführung ist die erste Öffnung zur Aufnahme einer Stirnfläche eines Piezoaktors vorgesehen. Die wenigstens eine weitere Öffnung ist zum Einbringen eines Befüllelements in einen Innenraum der Hülse zum Befüllen der Hülse mit einer Vergussmasse vorgesehen.

Der radiale Versatz zwischen der ersten und der zweiten Öffnung ermöglicht, dass die Befüllöffnung des Befüllelements an dem Piezoaktor entlang in den Innenraum der Hülse eingebracht werden kann. Die zweite oder weitere Öffnung ist beispielsweise eine Bohrung.

In einer Ausführungsform ist die Hülse einstückig ausgebildet.

Es wird weiterhin eine Aktoreinheit angegeben. Die Aktoreinheit umfasst einen Piezoaktor. Die Aktoreinheit umfasst weiterhin die vorher beschriebene Hülse. Der Piezoaktor ist zumindest teilweise in der ersten Öffnung der Hülse angeordnet.

In einer Ausführungsform weist die Aktoreinheit eine den Piezoaktor umgebende Vergussmasse auf. Der Piezoaktor weist eine erste Stirnfläche und eine zweite Stirnfläche auf. Die Vergussmasse reicht bis maximal an die erste Stirnfläche des Piezoaktors reicht.

In einer Ausführungsform ist der Piezoaktor zumindest teilweise in der ersten Öffnung angeordnet. Insbesondere kann die zweite Stirnfläche des Piezoaktors aus der ersten Öffnung der Hülse herausragen.

Durch die einstückig ausgebildete Hülse kann ein Austreten der Vergussmasse an Verbindungsstellen verschiedener Hülsenteile vermieden werden. Des Weiteren kann durch die einstückige Ausführung der Hülse ein Verkanten des Piezoaktors an Verbindungsstellen von mehreren Hülsenteilen beim Einbringen des Piezoaktors vermieden werden.

In einer vorteilhaften Ausführung der Aktoreinheit verläuft die Hauptachse der Hülse durch die erste Öffnung. Oberhalb der ersten Öffnung ist der Piezoaktor angeordnet. Oberhalb der weiteren Öffnung ist lediglich die Vergussmasse angeordnet. Insbesondere ist über dem Bereich, den der Piezoaktor abdeckt, insbesondere über dem Bereich der ersten Öffnung, keine Vergussmasse vorhanden.

Die beschriebenen Gegenstände werden anhand der folgenden Ausführungsbeispiele und Figuren näher erläutert. Dabei zeigt:
- Figur 1: eine schematische Darstellung eines Piezoaktors,
- Figur 2: eine schematische Darstellung einer Aktoreinheit,
- Figur 3: eine schematische Darstellung der Aktoreinheit aus Figur 2 während des Vergießens,
- Figur 4: eine schematische Darstellung der Aktoreinheit aus Figur 2 während des Vergießens in einer weiteren Ausführungsform.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit bzw. zum besseren Verständnis übertrieben dick oder groß dimensioniert dargestellt sein.

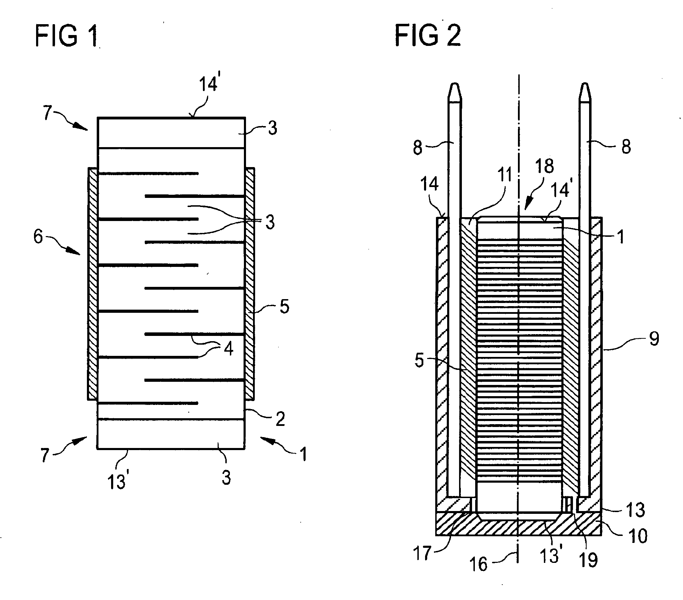

Figur 1 zeigt einen vielschichtigen Piezoaktor 1. Der Piezoaktor 1 weist einen Stapel 2 aus mehreren übereinander angeordneten piezoelektrischen Schichten 3 auf. Der Piezoaktor 1 weist eine erste Stirnfläche 14' und eine zweite Stirnfläche 13' auf.

Entlang der Stapelrichtung ist der Stapel 2 in einen aktiven Bereich 6 und zwei inaktive Bereiche 7 unterteilt. Die inaktiven Bereiche 7 grenzen in Stapelrichtung an den aktiven Bereich 6 an und bilden die Endstücke des Stapels 2. Der aktive Bereich 6 des Stapels 2 weist zwischen den piezoelektrischen Schichten 3 angeordnete Elektrodenschichten 4 auf. Um die Elektrodenschichten 4 im aktiven Bereich 6 einfach kontaktieren zu können, ist der Piezoaktor 1 so ausgebildet, dass sich nur jeweils der gleichen elektrischen Polarität zugeordnete Elektrodenschichten 4 bis zu einem Randbereich des Piezoaktors 1 erstrecken. Die der anderen elektrischen Polarität zugeordneten Elektrodenschichten 4 erstrecken sich an dieser Stelle nicht bis ganz zum Rand des Piezoaktors 1. Die Elektrodenschichten 4 sind demnach jeweils in Form von ineinander geschobenen Kämmen ausgebildet. Über Kontaktflächen in Form von Metallisierungen 5 an der Außenseite des Stapels 2 kann an die Elektrodenschichten 4 eine elektrische Spannung angelegt werden. Beim Anlegen einer Spannung an die Elektrodenschichten 4 tritt eine Verformung des piezoelektrischen Materials im aktiven Bereich 6 auf.

An den Metallisierungen 5 ist jeweils ein als Draht oder Pin ausgeführtes Anschlusselement 8 (siehe Figuren 2 bis 4) angebracht, welches eine elektrische Kontaktierung des Piezoaktors 1 nach außen ermöglicht.

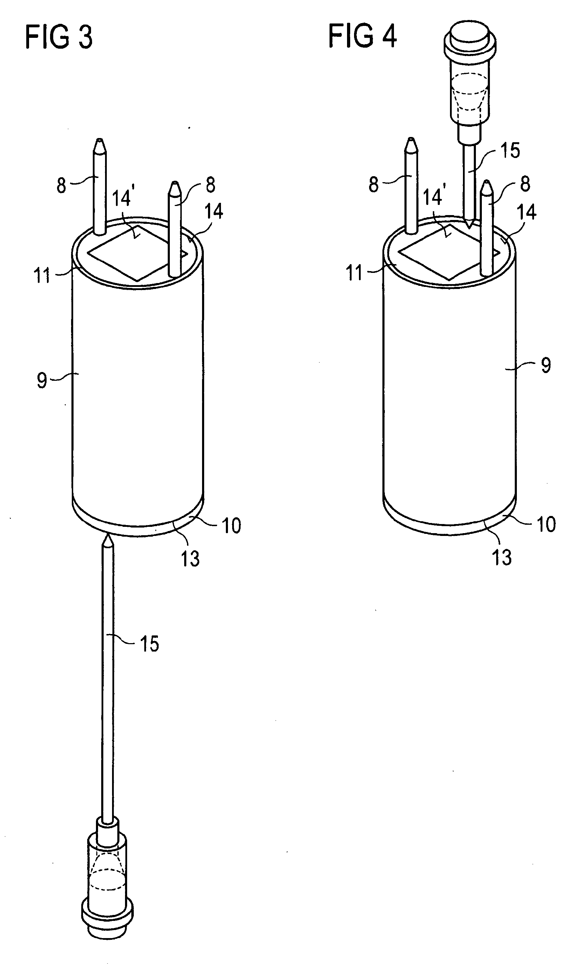

Figur 2 zeigt eine schematische Darstellung einer Aktoreinheit. Insbesondere zeigt Figur 2 die Aktoreinheit kurz vor dem Beenden von deren Herstellung, welche in den Figuren 3 und 4 im Detail beschrieben ist.

Die Aktoreinheit weist eine Hülse 9 auf. Die Hülse 9 ist zylinderförmig ausgebildet. Die Hülse 9 besteht beispielsweise aus Polybutylenterephthalat (PBT). Die Hülse 9 ist einstückig ausgeführt. Die Hülse 9 weist eine erste Stirnfläche oder Stirnseite 14 und eine zweite Stirnfläche oder Stirnseite 13 auf. Der Piezoaktor 1 aus Figur 1 ist in der Hülse 9 angeordnet. Der Piezoaktor 1 ist insbesondere derart in der Hülse 9 angeordnet, dass die erste Stirnfläche 14' des Piezoaktors 1 näher an der ersten Stirnfläche oder Stirnseite 14 der Hülse 9 angeordnet ist als die zweite Stirnfläche 13' des Piezoaktors 1.

Die erste Stirnfläche oder Stirnseite 14 der Hülse 9 weist eine Öffnung 18 auf. Die Öffnung 18 ist zur Aufnahme des Piezoaktors 1 in den Innenraum der Hülse 9 ausgelegt. Die Höhe bzw. Länge der Hülse 9 entspricht in etwa der Höhe des Piezoaktors 1. Insbesondere schließt in diesem Ausführungsbeispiel die erste Stirnfläche 14' des Piezoaktors 1 bündig mit der ersten Stirnfläche oder Stirnseite 14 der Hülse ab. Die erste Stirnfläche 14' des Piezoaktors 1 und die erste Stirnfläche oder Stirnseite 14 der Hülse weisen folglich die gleiche axiale Position in Bezug auf die Hauptachse 16 der Aktoreinheit oder der Hülse 9 auf, wobei sich die Hauptachse 16 zwischen der ersten Stirnfläche oder Stirnseite 14 und der zweiten Stirnfläche oder Stirnseite 13 der Hülse 9 erstreckt. Die Anschlusselemente 8 des Piezoaktors 1 ragen aus der ersten Stirnfläche 14' des Piezoaktors 1 und, folglich, auch aus der ersten Stirnfläche oder Stirnseite 14 der Hülse 9 heraus.

Die zweite Stirnfläche oder Stirnseite 13 der Hülse 9 bildet den Boden der Hülse 9. Die zweite Stirnfläche oder Stirnseite 13 weist eine Öffnung 17, insbesondere einen Durchbruch, auf. Der Durchbruch ist vorzugsweise ein Vierkantdurchbruck. Die Hauptachse 16 verläuft durch die Öffnung 17. Die zweite Stirnfläche 13' des Piezoaktors 1 ist in die Öffnung 17 eingeführt bzw. durch diese hindurchgeführt. Insbesondere ragt die zweite Stirnfläche 13' des Piezoaktors 1 aus der Öffnung 17 und somit über die zweite Stirnfläche oder Stirnseite 13 der Hülse 9 hinaus.

Zwischen der Öffnung 17 und dem Piezoaktor 1 kann es auf Grund von Fertigungstoleranzen zu einer Lücke bzw. einem Spalt (nicht explizit dargestellt) kommen. Durch diese Lücke kann Vergussmaterial 11 beim Vergießen der Aktoreinheit austreten. Um ein Austreten der Vergussmasse 11 aus der Öffnung 17 und, folglich, aus der Seite der zweiten Stirnfläche oder Stirnseite 13 der Hülse 9 zu verhindern, ist ein Dichtelement 10 an der zweiten Stirnfläche oder Stirnseite 13 der Hülse 9 angebracht. Das Dichtelement 10 verschließt die Seite der zweiten Stirnfläche oder Stirnseite 13 der Hülse 9.

Das Dichtelement 10 ist auf die Stirnfläche oder Stirnseite 13 der Hülse maschinell aufgepresst. Das Dichtelement 10 ist lösbar angebracht. Vorzugsweise ist das Dichtelement 10 lediglich während des Vergießens der Aktoreinheit sowie während eines anschließenden Aushärtevorgangs der Vergussmasse 11 angebracht, wie in Zusammenhang mit den Figuren 3 und 4 näher erläutert wird.

Das Dichtelement 10 ist eine Dichtscheibe. Das Dichtelement 10 ist verformbar. Das Dichtelement 10 besteht aus einem Schaumstoff. Beim Anbringen des Dichtelements 10 an die zweite Stirnfläche oder Stirnseite 13 der Hülse 9 passt sich das Dichtelement 10 an die aus der Seite der zweiten Stirnfläche oder Stirnseite 13 der Hülse 9 herausragende zweiten Stirnfläche 13' des Piezoaktors 1 an.

Die zweite Stirnfläche oder Stirnseite 13 weist gemäß diesem Ausführungsbeispiel eine weitere Öffnung 19 auf. Die Stirnfläche oder Stirnseite 13 kann eine Mehrzahl von weiteren Öffnungen 19 aufweisen. Die weitere Öffnung 19 ist bezüglich der Hauptachse 16 radial zur Öffnung 17 versetzt. Die weitere Öffnung 19 ist beispielsweise eine Bohrung. Die weitere Öffnung 19 dient beispielsweise zum Einbringen eines Befüllelements 15 (siehe insbesondere Figur 4) in den Innenraum der Hülse zum Befüllen der Hülse 9 mit der Vergussmasse 11. Oberhalb der weiteren Öffnung 19 ist Vergussmasse 11 angeordnet, wie aus Figur 2 ersichtlich ist.

Die Vergussmasse 11 umhüllt den Piezoaktor 1. Die Vergussmasse 11 enthält vorzugsweise ein Silikon-Elastomer. Zusätzlich zu dem Silikon-Elastomer kann die Vergussmasse 11 ein Quarzsand sowie haftvermittelnde Materialien aufweisen. Die Vergussmasse 11 steht mit der Außenseite des Piezoaktors 1 in Verbindung, d.h. sowohl mit Außenflächen der piezokeramischen Schichten 3 als auch mit den Außenflächen der Metallisierungen 5 sowie den Anschlusselementen 8. Nach außen wird die Vergussmasse 11 von der Hülse 9 begrenzt. In diesem Ausführungsbeispiel ist die Vergussmasse 11 auf Niveau aufgefüllt. Insbesondere schließt die Vergussmasse 1 bündig mit der ersten Stirnfläche 14' des Piezoaktors 1 und, folglich, mit der ersten Stirnfläche oder Stirnseite 14 der Hülse 9 ab. In einem weiteren Ausführungsbeispiel kann die Vergussmasse 11 auch bis knapp unterhalb der ersten Stirnfläche 14' des Piezoaktors 1 reichen. In jedem Fall überschreitet die Vergussmasse 11 das Niveau der ersten Stirnfläche 14' des Piezoaktors 1 nicht. Insbesondere ist der Bereich der Anschlusselemente 8, welcher aus der ersten Stirnfläche 14' des Piezoaktors 1 herausragt, frei von Vergussmasse 11. Aufwändige Reinigungsarbeiten der Anschlusselemente 8 nach dem Vergießen der Aktoreinheit entfallen dadurch. Ein automatischer Herstellungsprozess der Aktoreinheit wird somit erleichtert.

Die Figuren 3 und 4 zeigen die beschrieben Aktoreinheit aus während deren Herstellung, insbesondere während des Vergießens.

In einem ersten Schritt wird der Piezoaktor 1 über die Öffnung 18 in die Hülse 9 eingebracht. Die Piezoaktor 1 wird derart eingebracht, dass die zweite Stirnfläche 13' des Piezoaktors 1 in den Durchbruch 17 eingeführt wird, so dass die zweite Stirnfläche 13' des Piezoaktors 1 aus der zweiten Stirnfläche oder Stirnseite 13 der Hülse 9 hinausragt (siehe Figur 2). Die erste Stirnfläche 14' des Piezoaktors 1 schließt bündig mit der ersten Stirnfläche oder Stirnseite 14 der Hülse 9 ab, wie in Zusammenhang mit Figur 2 beschrieben wurde.

In einem zweiten Schritt wird das oben beschriebene Dichtelement 10 lösbar an der zweiten Stirnfläche oder Stirnseite 13 der Hülse 9 angebracht, vorzugsweise maschinell angepresst. Das Dichtelement 10 wird derart angebracht, dass die zweite Stirnfläche oder Stirnseite 13 gegen ein Austreten der Vergussmasse 11 beim Vergießen abgedichtet ist, wie in Zusammenhang mit Figur 2 beschrieben ist. Insbesondere wird durch das Dichtelement 10 der Spalt zwischen der umlaufenden Wand der Öffnung 17 und dem Piezoaktor 1 abgedichtet.

In einem dritten Schritt wird das Befüllelement 15, insbesondere eine Befüllöffnung des Befüllelements 15, in die Hülse 9, insbesondere in den Hohlraum zwischen der Innenwand der Hülse 9 und dem Piezoaktor 1, eingebracht. Die Befüllöffnung wird derart eingebracht, dass die Befüllöffnung vor Beginn des Einbringens der Vergussmasse 11 in einer axialen Position angeordnet ist, die nahe der axialen Position der zweiten Stirnfläche oder Stirnseite 13 der Hülse 9 in Bezug auf eine Hauptachse 16 liegt. Insbesondere wird die Befüllöffnung unmittelbar über der zweiten Stirnfläche oder Stirnseite 13 der Hülse angeordnet (nicht explizit dargestellt in den Figuren 3 und 4).

Das Befüllelement 15 kann von der Seite der ersten Stirnfläche oder Stirnseite 14 der Hülse 9 aus in den Hohlraum eingeführt werden, wie der Figur 4 entnommen werden kann. Insbesondere wird in diesem Fall das Befüllelement 15 über die Öffnung 18 in den Hohlraum eingebracht und bis zu der ersten Stirnfläche oder Stirnseite 13 der Hülse 9 am Piezoaktor 1 entlang vorgeschoben (nicht explizit dargestellt). In diesem Fall weist die Aktoreinheit keine weitere Öffnung 19 auf der Seite der zweiten Stirnfläche oder Stirnseite 13 der Hülse 9 zum Einbringen des Befüllelements 15 auf.

Alternativ dazu kann das Befüllelement 15 auch von der Seite der zweiten Stirnfläche oder Stirnseite 13 der Hülse 9 aus in den Hohlraum eingeführt werden, wie aus Figur 3 ersichtlich ist. Dafür weist die Hülse 9, insbesondere die zweite Stirnfläche oder Stirnseite 13 der Hülse 9, die wenigstens eine weitere Öffnung 19 (siehe Figur 2) auf, über die das Befüllelement 15 von der Seite der zweiten Stirnfläche oder Stirnseite 13 aus in den Hohlraum eingebracht wird. Beim Einbringen des Befüllelements 15, insbesondere der Befüllöffnung, in den Hohlraum über die Öffnung 19, wird das Dichtelement 10 durchstochen. Da das Dichtelement 10 aus einem flexiblen Material, beispielsweise Schaumstoff, besteht, schmiegt sich das Dichtelement 10 derart an das Befüllelement 15 an, dass es nicht zu einem Austreten der Vergussmasse 11 durch die Durchstechöffnung während des Vergießens kommt. Zudem verschließt sich die Durchstechöffnung nach dem Entfernen des Befüllelements 15 wieder automatisch, wodurch es beispielsweise während eines anschließenden Aushärtevorgangs zu keinem Austreten der Vergussmasse 11 durch die Durchstechöffnung kommt. Nachdem das Befüllelement 15 das Dichtelement 10 durchstochen hat, ist die Befüllöffnung des Befüllelement 15 unmittelbar über dem Boden, der durch die zweite Stirnfläche oder Stirnseite 13 der Hülse 9 gebildet ist, angeordnet.

In einem nächsten Schritt wird der Hohlraum zwischen der Innenseite der Hülse 9 und dem Piezoaktor 1 über die der Befüllöffnung des Befüllelements 15 mit der Vergussmasse 11 befüllt.

Wird das Befüllelement 15 über die Seite der ersten Stirnfläche oder Stirnseite 14 aus eingeführt (Figur 4), so wird beim Befüllen des Hohlraums das Befüllelement 15 in Richtung der ersten Stirnfläche oder Stirnseite 14 bewegt (nicht explizit dargestellt), so dass das Befüllelement 15, insbesondere die Befüllöffnung des Befüllelements 15, immer dicht über dem Vergussmassenniveau gehalten wird. Alternativ kann die Befüllöffnung des Befüllelements 15 auch knapp unterhalb des Vergussmassenniveaus gehalten werden. Durch das jeweilige Anordnen der Befüllöffnung in unmittelbarer Nähe des Vergussmassenniveaus wird ein gleichmäßiges Befüllen des Hohlraums ermöglicht. Turbulenzen in der Vergussmasse 11, die zu Lufteinschlüssen in der ausgehärteten Vergussmasse 11 führen können, werden vermieden.

Wird das Befüllelement 15 über die Seite der zweiten Stirnfläche oder Stirnseite 13 aus eingeführt (Figur 3), so verbleibt das Befüllelement 15 während des Befüllens des Hohlraums immer in der gleichen Position. Insbesondere wird die Vergussmasse 11 von der Seite der zweiten Stirnfläche oder Stirnseite 13 der Hülse 9 aus durch den Befülldruck in Richtung der Seite der ersten Stirnfläche oder Stirnseite 14 der Hülse 9 gedrückt. Somit wird ein gleichmäßiges Befüllen des Hohlraums sichergestellt und Turbulenzen, die zu Lufteinschlüssen in der ausgehärteten Vergussmasse 11 führen können, werden vermieden.

Der Hohlraum wird so lange befüllt, bis die Vergussmasse 11 bis an die erste Stirnfläche 14' des Piezoaktors 1 reicht. Sobald die Vergussmasse 11 das Niveau der ersten Stirnfläche 14' des Piezoaktors 1 erreicht hat, wird der Befüllvorgang gestoppt.

Nach dem Befüllen des Hohlraums wird das Befüllelement 15 entfernt. Insbesondere bei dem in Figur 3 dargestellten Ausführungsbeispiel wird das Befüllelement 15 zurück in Richtung der zweiten Stirnfläche oder Stirnseite 13 der Hülse 9 bewegt. Die Befüllöffnung wird dann aus der Öffnung 19 herausgeführt und anschließend aus dem Dichtelement 10 herausgezogen. Bei dem in Figur 4 dargestellten Ausführungsbeispiel befindet sich das Befüllelement 15 nach Beenden des Befüllvorgangs bereits in unmittelbarer Nähe der ersten Stirnfläche oder Stirnseite 14 der Hülse 9 und wird in Richtung der ersten Stirnfläche oder Stirnseite 14 gezogen und somit aus der Aktoreinheit entfernt.

In einem nächsten Schritt wird die Vergussmasse 11 ausgehärtet. Dies kann über mehrere Stunden hinweg in einem Ofen bei hohen Temperaturen durchgeführt werden.

Nach dem Aushärten der Vergussmasse 11 wird in einem letzten Schritt das Dichtelement 10, vorzugsweise automatisch, von der zweiten Stirnfläche oder Stirnseite 13 der Hülse 9 entfernt.

### Bezugszeichenliste

- 1: Piezoaktor
- 2: Stapel
- 3: Piezoelektrische Schicht
- 4: Elektrodenschicht
- 5: Metallisierung
- 6: Aktiver Bereich
- 7: Inaktiver Bereich
- 8: Anschlusselement
- 9: Hülse
- 10: Dichtelement
- 11: Vergussmasse
- 13: Stirnfläche oder Stirnseite
- 14: Stirnfläche oder Stirnseite
- 13': Stirnfläche
- 14': Stirnfläche
- 15: Befüllelement
- 16: Hauptachse
- 17: Öffnung
- 18: Öffnung
- 19: Öffnung

## Patentansprüche

1. Verfahren zur Herstellung einer Aktoreinheit aufweisend einen Piezoaktor (1), eine Hülse (9) mit einer ersten Stirnseite (14) und einer zweiten Stirnseite (13) sowie eine Vergussmasse (11), wobei das Verfahren die folgenden Schritte umfasst:
- Einbringen des Piezoaktors (1) in die Hülse (9), wobei der Piezoaktor (1) von der Seite der Hülse (9) mit der ersten Stirnseite (14) aus in die Hülse (9) eingebracht wird,
- Anordnen einer Befüllöffnung eines Befüllelements (15) in einer axialen Position nahe der axialen Position der zweiten Stirnseite (13) der Hülse (9) in Bezug auf eine Hauptachse (16)der Hülse (9),
- Befüllen eines Hohlraums, der zwischen einer Innenseite der Hülse (9) und dem Piezoaktor (1) gebildet ist, mit der Vergussmasse (11) über die Befüllöffnung des Befüllelements (15), derart, dass die Vergussmasse (11) bis maximal an eine erste Stirnfläche (14') des Piezoaktors (1) reicht, wobei die erste Stirnfläche (14') des Piezoaktors (1) näher an der ersten Stirnseite (14) der Hülse (9) angeordnet ist als eine zweite Stirnfläche (13') des Piezoaktors (1),
- Anordnen eines Dichtelements (10) an der zweiten Stirnseite (13) der Hülse (9) zum Abdichten der Hülse (9) auf der Seite der zweiten Stirnseite (13) vor dem Befüllen des Hohlraums,
- Aushärten der Vergussmasse (11), **gekennzeichnet durch** ein
- Entfernen des Dichtelements (9) von der zweiten Stirnseite (13) der Hülse (9) nach dem Aushärtevorgang.

2. Verfahren nach Anspruch 1,
wobei die zweite Stirnseite (13) der Hülse (9) einen Boden der Hülse (9) bildet, die zweite Stirnseite (13) eine Öffnung (17) aufweist, und der Piezoaktor (1) derart in die Hülse (9) eingebracht wird, dass der Piezoaktor (1) in die Öffnung (17) eintritt.

3. Verfahren nach Anspruch 2,
wobei das Dichtelement (16) derart an der zweiten Stirnseite (13) der Hülse (9) angeordnet wird, dass ein Austreten der Vergussmasse (11) aus der Hülse (9) über die Öffnung (17) der zweiten Stirnseite (13) der Hülse (9) beim Befüllen des Hohlraums verhindert wird.

4. Verfahren nach einem der vorigen Ansprüche,
wobei das Befüllelement (15) von der ersten Stirnseite (14) der Hülse (9) aus in die Hülse (9) eingeführt wird.

5. Verfahren nach einem der vorigen Ansprüche,
wobei das Befüllelement (15) während des Befüllens des Hohlraums mit der Vergussmasse (11) von der zweiten Stirnseite der Hülse (9) weg in Richtung der ersten Stirnseite (14) der Hülse (9) bewegt wird.

6. Verfahren nach einem der vorigen Ansprüche,
wobei die Befüllöffnung des Befüllelements (15) während des Befüllens des Hohlraums oberhalb oder knapp unterhalb des Vergussmassenniveaus im Hohlraum gehalten wird.

7. Verfahren nach einem der vorigen Ansprüche,
wobei das Befüllelement (15) von der zweiten Stirnseite (13) der Hülse (9) aus in die Hülse (9) eingebracht wird.

8. Verfahren nach Anspruch 7,
wobei die zweite Stirnseite (13) der Hülse (9) wenigstens eine Einfüllöffnung (19) aufweist, und wobei das Befüllelement (15) zum Befüllen des Hohlraums mit der Vergussmasse (11) über die Einfüllöffnung (19) in der zweiten Stirnseite (13) in den Hohlraum eingeführt wird.

9. Verfahren nach Anspruch 1 und einem der Ansprüche 7 und 8,
wobei die Befüllöffnung des Befüllelements (15) in eine erste Seite des Dichtelements (10) eingeführt wird und an einer zweiten Seite des Dichtelements (10) wieder austritt.

10. Verfahren nach einem der vorigen Ansprüche,
wobei der Hohlraum so lange mit der Vergussmasse (11) befüllt wird, bis die Vergussmasse (11) mit der ersten Stirnfläche (14') des Piezoaktors (1) bündig abschließt und das Befüllen daraufhin gestoppt wird, so dass die Vergussmasse (11) das Niveau der ersten Stirnfläche (14') des Piezoaktors nicht überschreitet.

11. Verfahren nach einem der vorigen Ansprüche,
wobei der Piezoaktor (1) derart in die Hülse (9) eingebracht wird, dass die erste Stirnfläche (14') des Piezoaktors (1) und die erste Stirnseite (14) der Hülse (9) die gleiche axiale Position in Bezug auf die Hauptachse (16) aufweisen.

12. Verfahren nach einem der vorigen Ansprüche,
wobei das Befüllelement (15) eine Nadel ist.

## Claims

1. Method for producing an actuator unit having a piezo actuator (1), a sleeve (9) with a first end face (14) and a second end face (13), and a sealing compound (11), wherein the method comprises the following steps:
- introducing the piezo actuator (1) into the sleeve (9), wherein the piezo actuator (1) is introduced into the sleeve (9) from the side of the sleeve (9) with the first end face (14),
- arranging a filling orifice of a filling element (15) in an axial position close to the axial position of the second end face (13) of the sleeve (9) with respect to a main axis (16) of the sleeve (9),
- filling a cavity that is formed between an inner side of the sleeve (9) and the piezo actuator (1) with the sealing compound (11) via the filling orifice of the filling element (15) in such a way that the sealing compound (11) reaches no further than a first end face (14') of the piezo actuator (1), wherein the first end face (14') of the piezo actuator (1) is arranged closer to the first end face (14) of the sleeve (9) than a second end face (13') of the piezo actuator (1), arranging a sealing element (10) on the second end face (13) of the sleeve (9) in order to seal off the sleeve (9) on the side of the second end face (13) before the cavity is filled,
- curing the sealing compound (11), **characterized by**
- removing the sealing element (10) from the second end face (13) of the sleeve (9) after the curing process.

2. Method according to Claim 1, wherein the second end face (13) of the sleeve (9) forms a base of the sleeve (9), the second end face (13) has an orifice (17), and the piezo actuator (1) is introduced into the sleeve (9) such that the piezo actuator (1) enters the orifice (17).

3. Method according to Claim 2, wherein the sealing element (16) is arranged on the second end face (13) of the sleeve (9) in such a way that emergence of the sealing compound (11) from the sleeve (9) via the orifice (17) of the second end face (13) of the sleeve (9) is prevented during the filling of the cavity.

4. Method according to one of the preceding claims, wherein the filling element (15) is inserted into the sleeve (9) from the first end face (14) of the sleeve (9).

5. Method according to one of the preceding claims, wherein during the filling of the cavity with the sealing compound (11) the filling element (15) is moved away from the second end face of the sleeve (9) toward the first end face (14) of the sleeve (9).

6. Method according to one of the preceding claims, wherein the filling orifice of the filling element (15) is kept above or just below the level of the sealing compound in the cavity during the filling of the cavity.

7. Method according to one of the preceding claims, wherein the filling element (15) is introduced into the sleeve (9) from the second end face (13) of the sleeve (9).

8. Method according to Claim 7, wherein the second end face (13) of the sleeve (9) has at least one filler orifice (19), and wherein, in order to fill the cavity with the sealing compound (11), the filling element (15) is inserted into the cavity via the filler orifice (19) in the second end face (13).

9. Method according to Claim 1 and one of Claims 7 and 8, wherein the filling orifice of the filling element (15) is inserted into a first side of the sealing element (10) and emerges again on a second side of the sealing element (10).

10. Method according to one of the preceding claims, wherein the cavity is filled with the sealing compound (11) until the sealing compound (11) finishes flush with the first end face (14') of the piezo actuator (1) and the filling process is stopped so that the sealing compound (11) does not exceed the level of the first end face (14') of the piezo actuator.

11. Method according to one of the preceding claims, wherein the piezo actuator (1) is introduced into the sleeve (9) in such a way that the first end face (14') of the piezo actuator (1) and the first end face (14) of the sleeve (9) have the same axial position with respect to the main axis (16).

12. Method according to one of the preceding claims, wherein the filling element (15) is a needle.

## Revendications

1. Procédé de fabrication d'une unité d'actionneur présentant un piézoactionneur (1), une douille (9) dotée d'un premier côté frontal (14) et d'un deuxième côté frontal (13) ainsi qu'une pâte de coulée (11), le procédé comportant les étapes suivantes :
placement du piézoactionneur (1) dans la douille (9), le piézoactionneur (1) étant placé dans la douille (9) depuis le côté de la douille (9) qui présente le premier côté frontal (14),
agencement d'une ouverture de remplissage d'un élément de remplissage (15) dans une position axiale proche de la position axiale du deuxième côté frontal (13) de la douille (9) par rapport à l'axe principal (16) de la douille (9),
remplissage de la cavité formée entre le côté intérieur de la douille (9) et le piézoactionneur (1) par la pâte de coulée (11), par l'intermédiaire de l'ouverture de remplissage de l'élément de remplissage (15) de telle sorte que la pâte de coulée (11) atteigne au plus une première surface frontale (14') du piézoactionneur (1), la première surface frontale (14') du piézoactionneur (1) étant située plus près du premier côté frontal (14) de la douille (9) qu'une deuxième surface frontale (13') du piézoactionneur (1),
agencement d'un élément d'étanchéité (10) sur le deuxième côté frontal (13) de la douille (9) pour rendre la douille (9) étanche sur le côté du deuxième côté frontal (13) avant le remplissage de la cavité,
durcissement de la pâte de coulée (11), **caractérisé par**
l'enlèvement de l'élément d'étanchéité (10) du deuxième côté frontal (13) de la douille (9) après l'opération de durcissement.

2. Procédé selon la revendication 1, dans lequel le deuxième côté frontal (13) de la douille (9) forme un fond de la douille (9), le deuxième côté frontal (13) présentant une ouverture (17) et le piézoactionneur (1) étant placé dans la douille (9) de telle sorte que le piézoactionneur (1) pénètre dans l'ouverture (17).

3. Procédé selon la revendication 2, dans lequel l'élément d'étanchéité (16) est disposé sur le deuxième côté frontal (13) de la douille (9) de manière à empêcher la sortie de la pâte de coulée (11) hors de la douille (9) par l'ouverture (17) du deuxième côté frontal (13) de la douille (9) lors du remplissage de la cavité.

4. Procédé selon l'une des revendications précédentes, dans lequel l'élément de remplissage (15) est inséré dans la douille (9) par le premier côté frontal (14) de la douille (9).

5. Procédé selon l'une des revendications précédentes, dans lequel l'élément de remplissage (15) est déplacé en direction du premier côté frontal (14) de la douille (9) pendant le remplissage de la cavité par la pâte de coulée (11) depuis le deuxième côté frontal de la douille (9).

6. Procédé selon l'une des revendications précédentes, dans lequel l'ouverture de remplissage de l'élément de remplissage (15) est maintenue au-dessus ou juste en dessous du niveau de la pâte de coulée dans la cavité pendant le remplissage de la cavité.

7. Procédé selon l'une des revendications précédentes, dans lequel l'élément de remplissage (15) est placé dans la douille (9) par le deuxième côté frontal (13) de la douille (9).

8. Procédé selon la revendication 7, dans lequel le deuxième côté frontal (13) de la douille (9) présente au moins une ouverture de remplissage (19), l'élément de remplissage (15) étant inséré dans la cavité pour remplir la cavité par la pâte de coulée (11), par l'ouverture de remplissage (19) ménagée dans le deuxième côté frontal (13).

9. Procédé selon la revendication 1 et l'une des revendications 7 et 8, dans lequel l'ouverture de remplissage de l'élément de remplissage (15) est insérée dans un premier côté de l'élément d'étanchéité (10) et ressort par un deuxième côté de l'élément d'étanchéité (10).

10. Procédé selon l'une des revendications précédentes, dans lequel la cavité est remplie de pâte de coulée (11) jusqu'à ce que la pâte de coulée (11) se raccorde à chant avec la première surface frontale (14') du piézoactionneur (1), le remplissage étant alors arrêté de telle sorte que la pâte de coulée (11) ne dépasse pas le niveau de la première surface frontale (14') du piézoactionneur.

11. Procédé selon l'une des revendications précédentes, dans lequel le piézoactionneur (1) est placé dans la douille (9) de telle sorte que la première surface frontale (14') du piézoactionneur (1) et le premier côté frontal (14) de la douille (9) présentent la même position axiale par rapport à l'axe principal (16).

12. Procédé selon l'une des revendications précédentes, dans lequel l'élément de remplissage (15) est une aiguille.
